# EUROPÄISCHE PATENTSCHRIFT

(11) **EP 0 928 067 B1**
(45) Veröffentlichungstag und Bekanntmachung des Hinweises auf die Patenterteilung: **14.05.2003**
(21) Anmeldenummer: 98117838.7
(22) Anmeldetag: 21.09.1998
(51) Int. Cl.: H03K 17/16, H03K 19/003

(54) **Ausgangspuffer zur Reduzierung von Störungen infolge des Schaltens eines Ausgangstreibers**
Output buffer noise reduction circuit
Circuit de réduction de bruit pour tampon de sortie

(30) Priorität: 30.09.1997 DE 19743284
(43) Veröffentlichungstag der Anmeldung: 07.07.1999
(73) Patentinhaber: Infineon Technologies AG, 81669 München (DE)
(72) Erfinder: Bartenschlager, Rainer, 87600 Kaufbeuren (DE); Schneider, Ralf, 81925 München (DE); Sichert, Christian, 81827 München (DE); Manyoki, Zoltan, 81739 München (DE)
(74) Vertreter: Müller - Hoffmann & Partner

(56) Entgegenhaltungen:
- EP-A- 0 390 226
- US-A- 5 428 303

## Beschreibung

Die vorliegende Erfindung betrifft eine Schaltungsanordnung zur Reduzierung von Störungen infolge des Schaltens eines Ausgangstreibers, bei der den einzelnen Stufen zum Ein- und Ausschalten des Ausgangstreibers ein Schaltsignal mit zeitlicher Verzögerung zwischen den einzelnen Stufen zugeführt ist, um den Ausgangstreiber stufenweise zu schalten. Derartige Schaltungsanordnungen sind beispielsweise aus DE 42 00 680 A1 und dem Fachbuch "Digital MOS Integrated Circuit II", Mohamed I. Elmasry, 1992, ISBN O-87942-275-0, Seiten 385 bis 392, insbesondere Bild 5 auf Seite 388, bekannt.

In digitalen Halbleiterbauelementen mit einer großen Anzahl von Ausgängen, wie beispielsweise 16 oder mehr Ausgängen, tritt eine erhebliche Störung der Versorgungsspannung auf, wenn die Ausgangstreiberstufen an den jeweiligen Ausgängen gleichzeitig geschaltet werden. Diese Erscheinung ist unter anderem als "dI/dt noise", "groundbounce", "simultaneous switching noise" usw. allgemein bekannt. Dabei sind die Störungen am größten, wenn hohe Ausgangsströme ein- und ausgeschaltet werden.

Dies bedeutet, daß beim gleichzeitigen Schalten mehrerer Ausgangstreiberstufen die auf die Versorgungsspannung einwirkende Störung um so größer ist, je höher die Versorgungsspannung ist, da eine hohe Versorgungsspannung eben zum Schalten von großen Ausgangsströmen benötigt wird.

Um nun hier Abhilfe zu schaffen, gibt es bereits eine Schaltungsanordnung, bei der parallel zueinander liegende Ausgangstreiberstufen nicht mehr gleichzeitig, sondern zeitlich verzögert geschaltet werden, um die durch gleichzeitiges Schalten bedingte Störung der Versorgungsspannung zu reduzieren. Durch dieses zeitlich verzögerte oder gestaffelte Schalten der einzelnen parallel zueinander liegenden Ausgangstreiberstufen werden die Stromänderungen begrenzt, die infolge der parasitären Induktivitäten der digitalen Halbleiterbauelemente bedingt sind.

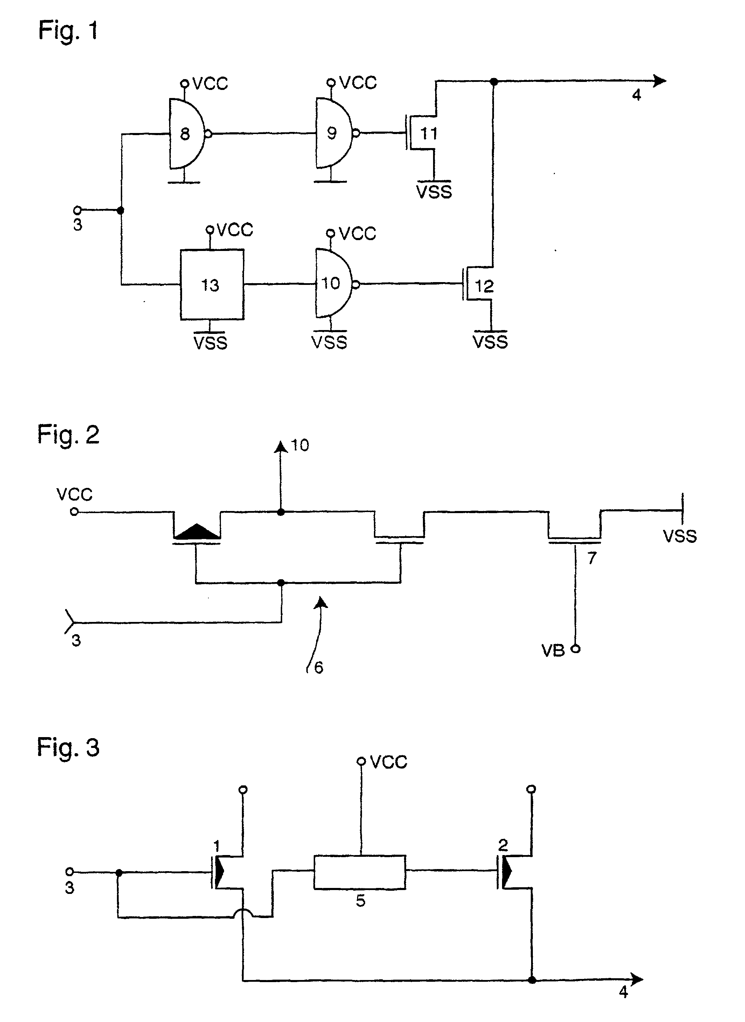

In Fig. 3 ist eine solche Schaltungsanordnung mit Ausgangstreiberstufen 1, 2 gezeigt, die über einen Eingangsanschluß 3 angesteuert sind und parallel zu einem Ausgangsanschluß 4 liegen. Die Ansteuerung der Ausgangstreiberstufen 1, 2 erfolgt nun so, daß zunächst die Ausgangstreiberstufe 1 und anschließend die Ausgangstreiberstufe 2 angesteuert wird, wobei diese Verzögerung durch ein Verzögerungsglied 5 bewirkt wird. Das Verzögerungsglied 5 arbeitet dabei so, daß die von ihm gelieferte zeitliche Verzögerung mit zunehmender Versorgungsspannung VCC abnimmt.

An sich bietet das zeitlich verzögerte Schalten der einzelnen Ausgangstreiber zueinander erhebliche Vorteile hinsichtlich der Reduzierung der genannten Störungen der Versorgungsspannung. Dieser Vorteil wird aber damit erkauft, daß durch das zeitlich verzögerte Einschalten der einzelnen Ausgangstreiberstufen die gesamte Signalverzögerung einer entsprechenden Schaltungsanordnung erhöht wird. Dieser unerwünschte Effekt ist zudem dann am stärksten, wenn die zeitliche Verzögerung zwischen dem Einschalten der einzelnen Ausgangstreiberstufen am längsten ist, d.h., bei niedriger Versorgungsspannung. Die Ursache hierfür liegt darin, daß bei den herkömmlichen Schaltungsanordnungen, die übliche Ausgangstreiber verwenden, die Signalverzögerung mit niedrigerer Versorgungsspannung länger wird. Mit anderen Worten, je höher die Versorgungsspannung ist, desto kürzer ist die zeitliche Verzögerung zwischen den einzelnen Ausgangstreiberstufen. Dies bedeutet aber, daß bei höherer Versorgungsspannung, wenn ohnehin die meisten Störungen auftreten, der Effekt der Störungsreduzierung am geringsten ist. Aus diesem Grund arbeiten die bestehenden Schaltungsanordnungen zur Reduzierung von Störungen infolge des Schaltens eines Ausgangstreibers speziell bei hohen Versorgungsspannungen vollkommen unbefriedigend, da durch die kürzer werdende zeitliche Verzögerung zwischen den Ausgangstreiberstufen Störungen immer weniger vermieden werden.

Es ist daher Aufgabe der vorliegenden Erfindung, eine Schaltungsanordnung der eingangs genannten Art so zu verbessern, daß diese auch bei hohen Versorgungsspannungen für eine zuverlässige Störungsreduzierung zu sorgen vermag.

Diese Aufgabe wird bei einer Schaltungsanordnung zur Reduzierung von Störungen infolge des Schaltens eines Ausgangstreibers erfindungsgemäß dadurch gelöst, daß dem Ausgangstreiber ein Einschaltsignal um so später zugeleitet ist, je höher die Versorgungsspannung ist. Mit anderen Worten, bei der erfindungsgemäßen Schaltungsanordnung wird die Signalverzögerung des Einschaltsignales um so größer, je höher die Versorgungsspannung wird.

Wesentlich an der erfindungsgemäßen Schaltungsanordnung ist also, daß die Verzögerung zwischen dem Einschalten oder Ausschalten der einzelnen Ausgangstreiberstufen mit steigender Versorgungsspannung größer wird. Damit werden Störungen nur dann reduziert, wenn dies tatsächlich erforderlich ist, nämlich bei höher werdenden Versorgungsspannungen. Im "schlimmsten Fall", wenn die Versorgungsspannung sehr hoch ist und damit auch die Störungen groß sind, ist die Verzögerung am größten, was wiederum die stärkste Reduzierung der Störungen nach sich zieht.

Die Ausführung der Verzögerungsschaltung, die bewirkt, daß den Ausgangstreiberstufen Einschaltsignale oder Ausschaltsignale um so später zugeführt werden, je höher die Versorgungsspannung ist, kann auf verschiedene Weise geschehen. Ein mögliches Beispiel besteht darin, daß ein herkömmlicher CMOS-Inverter mit einer Stromquelle als Verzögerungsschaltung herangezogen wird. Die Stromquelle begrenzt hier den sogenannten "Pull-down"-Strom des Inverters, so daß bei zunehmender Versorgungsspannung die nachgeschaltete Ausgangstreiberstufe später ein- bzw. ausgeschaltet wird.

Nachfolgend wird die Erfindung anhand der Zeichnungen näher erläutert. Es zeigen:
- Fig. 1: ein Ausführungsbeispiel der erfindungsgemäßen Schaltungsanordnung,
- Fig. 2: eine mögliche vorteilhafte Ausführungsform für die Verzögerungsschaltung, und
- Fig. 3: ein Prinzipschaltbild mit zwei Ausgangstreiberstufen und einer bestehenden Verzögerungsschaltung.

Fig. 3 ist bereits eingangs erläutert worden. In den Figuren werden für einander entsprechende Bauteile die gleichen Bezugszeichen verwendet.

Fig. 1 zeigt ein Ausführungsbeispiel der erfindungsgemäßen Schaltungsanordnung. Einem Eingangsanschluß 3 sind eine Ausgangstreiberstufe 11 aus einem N-Kanal-MOS-Transistor über Inverter 8, 9 und eine Ausgangstreiberstufe 12 aus ebenfalls einem N-Kanal-MOS-Transistor über ein Verzögerungsglied 13 und einen Inverter 10 nachgeschaltet. Die Inverter 8, 9 und 10 und das Verzögerungsglied 13 liegen daher zwischen der Versorgungsspannung VCC und einer Bezugsspannung VSS.

Im Gegensatz zu dem Verzögerungsglied 5 der bestehenden Schaltungsanordnung (vgl. Fig. 3) arbeitet das Verzögerungsglied 13 so, daß die Verzögerung mit zunehmender Versorgungsspannung anwächst.

In Abkehr vom Stand der Technik hat also die erfindungsgemäße Schaltungsanordnung das Verzögerungsglied 13, bei dem die Verzögerung mit steigender Versorgungsspannung VCC größer wird. Das heißt, je höher die Versorgungsspannung VCC ist, um so größer ist die zeitliche Verzögerung zwischen dem Einschalten bzw. Ausschalten der Ausgangstreiberstufen 11 und 12.

Fig. 2 veranschaulicht ein mögliches Ausführungsbeispiel für das Verzögerungsglied 13. Bei diesem Ausführungsbeispiel besteht das Verzögerungsglied 13 aus einem CMOS-Inverter 6 und einer in Reihe hierzu liegenden Konstantstromquelle aus einem Transistor 7. Die Konstantstromquelle begrenzt den "Pulldown"-Strom des CMOS-Inverters 6, so daß hier die zwischen Eingang und Ausgang erhaltene Verzögerung mit steigender Versorgungsspannung VCC anwächst. Eine Versorgungsspannung VB am Gate des Transistors 7 dient dabei zur Einstellung der gewünschten Verzögerung.

## Patentansprüche

1. Schaltungsanordnung zur Reduzierung von Störungen infolge des Schaltens eines Ausgangstreibers (11, 12),
wobei der Ausgangstreiber (11, 12) mehrere parallel zueinander liegende Stufen aufweist, und Schaltmittel vorgesehen sind, welche den einzelnen Stufen zum Ein- und Ausschalten des Ausgangstreibers (11, 12) das Schaltsignal mit zeitlicher Verzögerung zwischen den einzelnen Stufen zuführen, um den Ausgangstreiber (11, 12) stufenweise zu schalten,
**dadurch gekennzeichnet,**
**daß** die zeitliche Verzögerung anwächst, je höher die an der Schaltungsanordnung anliegende Versorgungsspannung (VCC) ist.

2. Schaltungsanordnung nach Anspruch 1,
**dadurch gekennzeichnet,**
**daß** die Schaltmittel Verzögerungsglied (13) umfassen, welches vor einem der Ausgangstreiber (11, 12) geschaltet ist.

3. Schaltungsanordnung nach Anspruch 2,
**dadurch gekennzeichnet,**
**daß** das Verzögerungsglied (13) aus einem CMOS-Inverter (6) und einer in Reihe hierzu liegenden Konstantstromquelle besteht.

4. Schaltungsanordnung nach Anspruch 3,
**dadurch gekennzeichnet,**
**daß** die Konstantstromquelle einen Transistor (7) aufweist.

## Claims

1. Circuit arrangement for reducing disturbances on account of the switching of an output driver (11, 12), the output driver (11,12)
- having a plurality of stages connected in parallel with one another, and there being provided switching means which feed the switching signal to the individual stages for the purpose of switching the output driver (11, 12) on and off with a time delay between the individual stages, in orders to switch the output driver (11, 12) stage by stage,
**characterized in that**
time delay increases the higher the supply voltage (VCC) present at the circuit arrangement is.

2. Circuit arrangement according to Claim 1,
**characterized in that**
the switching means comprise a delay element (13) which is connected upstream of one of the output drivers (11, 12).

3. Circuit arrangement according to Claim 2,
**characterized in that**
the delay element (13) comprises a CMOS inverter (6) and a constant-current source connected in series therewith.

4. Circuit arrangement according to Claim 3,
**characterized in that**
the constant-current source has a transistor (7).

## Revendications

1. Montage de réduction des parasites dû à la commutation d'un tampon (11, 12) de sortie, dans lequel le tampon (11, 12) de sortie a plusieurs étages montés en parallèle, et il est prévu des moyens de commutation qui envoient aux divers étages pour la connexion et la déconnexion du tampon (11, 12) de sortie le signal de commutation avec un retard dans le temps entre les divers étages pour commuter étage par étage le tampon (11, 12) de sortie, **caractérisé en ce que** le retard dans le temps croît d'autant plus que la tension (VCC) d'alimentation appliquée au montage est plus grande.

2. Montage suivant la revendication 1, **caractérisé en ce que** les moyens de commutation comprennent un élément (13) à retard qui est commuté avant l'un des tampons (11, 12) de sortie.

3. Montage suivant la revendication 2, **caractérisé en ce que** l'élément (13) à retard est constitué d'un inverseur (6) CMOS et d'une source de courant constant en série avec celui-ci.

4. Montage suivant la revendication 3, **caractérisé en ce que** la source de courant constant comporte un transistor (7).
